# EUROPÄISCHE PATENTSCHRIFT

(11) **EP 0 986 846 B1**
(45) Veröffentlichungstag und Bekanntmachung des Hinweises auf die Patenterteilung: **01.08.2001**
(21) Anmeldenummer: 98934770.3
(22) Anmeldetag: 22.05.1998
(51) Int. Cl.: H01S 5/10

(54) **OPTOELEKTRONISCHES HALBLEITERBAUELEMENT**
OPTOELECTRONIC SEMICONDUCTOR COMPONENT
COMPOSANT OPTOELECTRONIQUE A SEMI-CONDUCTEUR

(30) Priorität: 05.06.1997 DE 19723677
(43) Veröffentlichungstag der Anmeldung: 22.03.2000
(73) Patentinhaber: Infineon Technologies AG, 81669 München (DE)
(72) Erfinder: FISCHER, Frank, 72770 Reutlingen (DE); REUSCHER, Günter, D-97074 Würzburg (DE); LITZ, Thomas, D-97074 Würzburg (DE); LANDWEHR, Gottfried, D-97074 Würzburg (DE)
(74) Vertreter: Zedlitz, Peter, Dipl.-Inf.
(86) Internationale Anmeldenummer: DE9801404
(87) Internationale Veröffentlichungsnummer: WO9856084

(56) Entgegenhaltungen:
- EP-A- 0 709 939
- WO-A-98/07218
- SUGG A R ET AL: "N-P-(P+-N+)-N ALYGA1-YAS-GAAS-INXGA1-XAS QUANTUM-WELL LASER WITH P+-N+ GAAS-INGAAS TUNNEL CONTACT ON N-GAAS" APPLIED PHYSICS LETTERS, Bd. 62, Nr. 20, 17. Mai 1993, Seiten 2510-2512, XP000303799
- CHUA C L ET AL: "LONG WAVELENGTH VCSELS USING ALAS/GAAS MIRRORS AND STRAIN- COMPENSATED QUANTUM WELLS" PROCEEDINGS OF THE IEEE/CORNELL CONFERENCE ON ADVANCED CONCEPTS IN HIGH SPEED SEMICONDUCTOR DEVICES AND CIRCUITS, ITHACA, NEW YORK, AUG. 7 - 9, 1995, 7. August 1995, Seiten 361-363, XP000626624 INSTITUTE OF ELECTRICAL AND ELECTRONICS ENGINEERS
- THIBEAULT B J ET AL: "REDUCED OPTICAL SCATTERING LOSS IN VERTICAL-CAVITY LASERS USING A THIN (300 A) OXIDE APERTURE" IEEE PHOTONICS TECHNOLOGY LETTERS, Bd. 8, Nr. 5, 1. Mai 1996, Seiten 593-595, XP000589250

## Beschreibung

Die Erfindung bezieht sich auf ein optoelektronisches Halbleiterbauelement mit einem zur Erzeugung elektromagnetischer Strahlung geeigneten Halbleiterkörper, bei dem über einem Halbleitersubstrat eine aktive Zone angeordnet ist, innerhalb der bei Stromfluß durch den Halbleiterkörper die elektromagnetische Strahlung erzeugt wird und die zwischen mindestens einer ersten Resonatorspiegelschicht und mindestens einer zweiten Resonatorspiegelschicht angeordnet ist.

Ein optoelektronisches Halbleiterbauelement mit einem derartigen Halbleiterkörper ist beispielsweise der sogenannte Vertical Cavity Surface Emitting Laser (kurz VCSEL genannt). Bei diesem Bauelement wird das in der aktiven Zone einer Heterostruktur erzeugte Licht senkrecht zu der die aktive Zone aufweisenden Schichtstruktur zwischen den beiden Resonatorspiegelschichten, also in Stromflußrichtung, reflektiert und in steilem Winkel zur Oberfläche der Halbleiter-Heterostruktur durch eine der Reflektorspiegelschichten hindurch aus dem Halbleiterkörper ausgekoppelt.

Ein derartiges optoelektronisches Halbleiterbauelement und dessen Funktionsprinzip ist beispielsweise aus W.Bludau, Halbleiter-Optoelektronik, Hansa-Verlag, München, Wien, 1995, Seiten 188 und 189 bekannt. Hierin ist eine VCSEL-Diode beschrieben, bei dem auf einem n-leitenden Substrat ein Halbleiterkörper aufgebracht ist, der aus einer ersten Schichtfolge aus n-dotierten Spiegelschichten (untere Resonatorspiegelschicht), einem Bereich mit der aktiven Zone und einer zweiten Schichtfolge aus p-dotierten Spiegelschichten (obere Resonatorspiegelschicht) besteht. Der elektrische Anschluss des Halbleiterkörpers ist durch einen ohmschen Oberseitenkontakt auf dem oberen Spiegel und einen Unterseitenkontakt an dem Substrat realisiert. Die genaue Funktionsweise ist in der oben genannten Textstelle beschrieben und wird von daher an dieser Stelle nicht mehr näher erläutert.

Die untere Resonatorspiegelschicht ist beispielsweise eine mit Silizium n-leitend dotierte, epitaktisch vor dem Abscheiden der aktiven Schichtfolge auf dem Halbleitersubstrat aufgebrachte periodische Folge von abwechselnd GaAs- oder AlGaAs- und AlAs- oder AlGaAs-Schichten mit hohem bzw. niedrigen Brechungsindex, deren jeweilige Schichtdicke ¼ der von der aktiven Zone emittierten Wellenlänge dividiert durch den Materialbrechungsindex ist. Das Reflektionsvermögen des Spiegels wird durch die Anzahl der Schichtpaare eingestellt. Auf diesem n-leitenden sogenannten Bragg-Reflektor ist beispielsweise eine n-leitende erste Barriereschicht, z. B. bestehend aus AlGaAs, eine aktive Zone, z. B. mit einer InGaAs/GaAs-Multiquantentrogstruktur (MQW) und eine p-leitende zweite Barriereschicht, z.B. bestehend aus AlGaAs, aufgebracht, derart, daß die aktive Zone zwischen den Barriereschichten eingebettet ist.

An die p-leitende zweite Barriereschicht grenzt die obere Resonatorspiegelschicht, z. B. ein mit Beryllium oder Kohlenstoff p-leitend dotierter GaAs/AlAs-Bragg-Reflektor, auf dessen Oberseite der ohmsche Oberseitenkontakt angeordnet ist. Nach Anlegen einer elektrischen Spannung zwischen Oberseiten- und Unterseitenkontakt, derart, daß der pn-Übergang der aktiven Zone in Durchlassrichtung gepolt ist, werden im gewählten Beispiel negative Ladungsträger von der Substratseite durch den n-leitenden unteren Bragg-Spiegel in die aktive Zone injiziert. Löcher werden vom Oberseitenkontakt durch den p-leitenden oberen Bragg-Reflektor injiziert.

Ähnliche optoelektronische Halbleiterbauelemente sind beispielsweise in Iga,Inst.Phys Conf.Ser. 145 (8), 1996, Seiten 967 bis 972, beschrieben und können für verschiedene Längenwellenbereiche der elektromagnetischen Strahlung aus unterschiedlichen Materialien hergestellt sein.

Beim Konzept der VCSEL können viele Laser in lateraler Richtung auf einem Halbleitersubstrat definiert und somit leicht Laser-Arrays ausgebildet werden, die gegenüber den sogenannten SCH(Seperate Confinement Heterostructure)-Lasern eine vorteilhaftere Strahlcharakteristik aufweisen.

In den oben aufgeführten Halbleiterlaser-Strukturen tritt das besondere Problem auf, dass der p-leitende Bragg-Reflektor aus GaAs/AlAs-, AlGaAs/AlAs- oder AlGaAs/GaAs-Schichtfolgen einen hohen elektrischen Widerstand aufweist und daher hohe elektrische Verluste hervorruft. Wegen der geringen Wärmeleitfähigkeit der oben genannten Materialien tritt folglich eine deutliche Erwärmung der Laserdiode im Betrieb auf. Dadurch wird beispielsweise die Lebensdauer von VCSEL-Lasern mit hoher optischer Ausgangsleistung stark begrenzt.

Darüber hinaus wird durch die großen Spannungsabfälle an den p-leitenden Spiegeln die Ansteuerung der Laserdiode mit einem Spannungspegel < 5V, der für logische Signale spezifiziert ist, verhindert.

Um dieses Problem zu mindern, werden die p-leitenden Spiegel-schichten in VCSEL-Strukturen meist auf der Seite der aktiven Zone, auf welcher die elektromagnetische Strahlung aus dem Halbleiterkörper ausgekoppelt wird, aufgebracht. Auf dieser Seite werden nämlich weniger Spiegelschichtpaare benötigt, um die Reflektivität dieser Seite gegenüber der gegenüberliegenden n-leitenden Resonator-Spiegelschicht zu senken, wodurch eine Auskopplung der Laserstrahlung möglich ist. Bei oberflächenemittierenden Lasern wird der Halbleiterkörper daher meist auf einem n-leitenden Substrat hergestellt, wodurch die p-leitende Oberseite positiv gegenüber der Substrat-Seite gepolt werden muß. Dieser Umstand ist nachteilig für die Ansteuerung der Laserdiode, vor allem, wenn es die gezielte, stromgeregelte Ansteuerung einer VCSEL-Diode in einem Laser-Array betrifft, wie es beispielsweise in EP 709 939 A1 behandelt ist.

Des Weiteren ist es nachteilig, die üblicherweise in den oben beschriebenen VCSEL-Strukturen verwendeten GaAs-Substrate aus p-leitendem GaAs herzustellen, da diese nur mit sehr großem technischen Aufwand mit hoher struktureller Qualität herstellbar sind. Sie sind von daher kommerziell nur mit einer deutlich geringeren strukturellen Qualität erhältlich als z. B. mit Si n-leitend dotierte GaAs-Substrate.

Es wurden bereits verschiedene Lösungsansätze verfolgt, den elektrischen Widerstand der p-leitenden Bragg-Reflektoren zu erniedrigen. In MG Peters et al., J.Vac. Sci. Technol. Band 12 (6) 1994, Seiten 3075 bis 3083, sind Verfahren beschrieben, bei welchen durch Manipulation der Grenzflächen-Materialübergänge und -Dotierung der Transport von Löchern in p-leitenden Bragg-Spiegel verbessert wird. Problematisch bei z. B. auf InGaAlAs basierenden Spiegeln für VCSEL ist die große effektive Masse der Löcher und eine hohe Energiebarriere beim Austritt von Löchern, z. B. aus einer GaAs-Schicht in eine AlAs-Schicht. Bei den angesprochenen Verfahren wird die Komposition des Materials in einer engen Zone um die GaAs/AlAs-Grenzfläche herum auf verschiedene Weise zwischen den binären Verbindungen GaAs und AlAs über eine AlGaAs-Legierung variiert und gleichzeitig durch geschickte Dotierung mit z. B. Be, C oder Si versucht, die Potentialbarriere abzuflachen und zu minimieren.

Eine weitere Methode wäre, an Stelle von GaAs die Verbindung AlGaAs in AlGaAs/AlAs-Bragg-Gittern oder an Stelle von AlAs die Verbindung AlGaAs in GaAs/AlGaAs-Bragg-Gittern zu verwenden. Damit wird die Barriere für Löcher erniedrigt, wodurch ein geringerer elektrischer Widerstand erreicht wird. Nachteilig hierbei ist jedoch, dass der Brechzahlunterschied zwischen AlGaAs und GaAs bzw. AlAs kleiner ist als im Fall der binären Spiegel aus GaAs/AlAs. Folglich müssen deutlich mehr Spiegelpaare aufgebracht werden, um eine ähnliche Reflektivität wie bei AlAs/GaAs-Schichtfolgen zu erzielen, wodurch der elektrische Widerstand wiederum erhöht wird.

Darüber hinaus ist die thermische Leitfähigkeit von AlGaAs deutlich geringer als von GaAs oder AlAs, wodurch die im Laser erzeugte thermische Energie nur in unzureichendem Maße abgeführt wird.

Eine die Erniedrigung des elektrischen Widerstandes in den oben genannten p-leitenden Bragg-Reflektorschichten einschränkende Erscheinung ist das Auftreten freier Ladungsträger-Absorption, die für Löcher deutlich höher ist, als für Elektronen. Dadurch können nicht beliebig hohe Akzeptor-Konzentrationen in den p-Bragg-Spiegeln verwendet werden. Bei der Verwendung von Be als Akzeptormaterial kommt es des Weiteren zu einer Diffusion des Dotierstoffes bei üblichen Her-stellungstemperaturen, wodurch eine Aufweichung des gewünschten Dotierprofiles an der Grenzfläche eintritt, die zu einer Erhöhung des Widerstandes und des Schwellstromes des VCSEL führt.

Bei anderen Halbleitermaterialien, die ebenfalls in VCSEL-Bauelementen eingesetzt werden, wie z. B. InGaAsP oder AlInGaAs oder II-VI-Halbleiter wie ZnMgSSe oder BeMgZnSe, treten ähnliche Bedingungen auf. Hier kommt noch hinzu, dass beispielsweise im Fall von VCSEL-Strukturen auf InP-Substrat die Herstellung p-leitender Spiegel erheblich schwieriger ist, da der Brechungsindexunterschied der verwendeten p-leitenden Spiegelpaare, die gitterangepasst an InP-Substrat sind, wie z. B. p-InP/p-InGaAsP, sehr gering ist und damit viele Spiegelpaare aufgebracht werden müssen.

Bei der Herstellung von VCSEL-Bauelementen, insbesondere von Bragg-Reflektorspiegelschichten, ist eine hohe Reproduzierbarkeit, mit der die Schichtdicken und Schichtzusammensetzungen bei der Herstellung mit Molekularstrahlepitaxie, (MBE) oder metallorganischer chemischer Gasphasenabscheidung (MOCVD) eingestellt werden können, eine Grundvoraussetzung für gleichbleibende Bauelementeigenschaften. Es sollte eine Genauigkeit von besser als 3% erreicht werden. Durch komplizierte Variationen an den Grenzflächen, insbesondere in den p-leitenden Spiegeln, ist diese Reproduzierbarkeit nur sehr schwierig zu erreichen.

EP-A-0 709 939 offenbart ein optoelektronisches Bauelement mit den Merkmalen des Oberbegriffs des Anspruches 1.

Der vorliegenden Erfindung liegt daher die Aufgabe zugrunde, ein verbessertes optoelektronisches Bauelement der eingangs genannten Art zu entwickeln, bei dem insbesondere der elektrische Widerstand des Halbleiterkörpers verringert ist.

Weiterhin soll ein verbessertes VCSEL-Bauelement zur Verfügung gestellt werden, bei welchem elektromagnetische Strahlung im Bereich zwischen 350 nm und 3 *µ*m erzeugt wird, wobei der elektrische Widerstand des Bauelementes klein ist, die entstehende thermische Energie gut abgeführt wird und dessen Herstellung vergleichsweise einfach ist.

Diese Aufgabe wird mit einem optoelektronischen Halbleiterbauelement mit den Merkmalen des Anspruches 1 gelöst. Vorteilhafte Weiterbildungen und Ausführungsformen des erfindungsgemäßen optoelektronischen Halbleiterbauelements ergeben sich aus den dem Anspruch 1 nachgeordneten Unteransprüchen.

Erfindungsgemäß ist vorgesehen, daß die erste und die zweite Resonatorspiegelschicht Halbleitermaterial eines ersten Leitungstyps aufweisen und daß zwischen der aktiven Zone und einer der beiden Resonatorspiegel-Schichten eine erste hochdotierte Übergangsschicht des ersten Leitungstyps und eine zweite hochdotierte Übergangsschicht eines zweiten Leitungstyps angeordnet sind, derart, daß die zweite hochdotierte entartete Übergangsschicht zwischen der aktiven Zone und der ersten hochdotierten entarteten Übergangsschicht liegt. Die erste und die zweite hochdotierte Übergangsschicht weisen bevorzugt eine Dotierstoffkonzentration > 1^{*}10¹⁷ cm⁻³ auf.

Bei dem erfindungsgemäßen optoelektronischen Halbleiterbauelement ist somit die aktive Zone zwischen zwei Resonatorspiegel-Schichten mit gleichem Leitungstyp angeordnet. Folglich ist in den Resonatorspiegel-Schichten nur ein Ladungsträgertyp zum elektrischen Transport verwendet. In den hochdotierten, entarteten Schichten werden diese Ladungsträger in den komplementären Ladungsträgertyp umgewandelt und in den pn-Übergang der aktiven Zone injiziert. Dabei ist die Folge entarteter Schichten in Rückwärtsrichtung (Sperrrichtung) gepolt.

Bei VCSEL-Strukturen auf der Basis von GaAs-Halbleitermaterial sind die Bragg-Reflektorspiegelschichten bevorzugt n-leitend ausgebildet, wodurch die beschriebenen Nachteile herkömmlicher VCSEL-Strukturen, insbesondere die Verwendung einer hochohmigen und stark absorptiven p-leitenden Resonatorspiegelschicht und/oder eines nur mit großem Aufwand herstellbaren p-leitenden GaAs-Substrats vermieden wird.

Die Folge hochdotierter Schichten kann auf der Seite der aktiven Zone liegen, auf welcher der Bragg-Reflektor mit der geringeren Reflektivität liegt. In einer anderen Ausgestaltung kann sie auf der Seite der aktiven Zone liegen, auf welcher der Bragg-Reflektor mit der höheren Reflektivität angeordnet ist.

Die elektromagnetische Strahlung wird entweder auf der dem Substrat gegenüberliegenden Seite des Halbleiterkörpers oder durch das Substrat oder ein Loch im Substrat hindurch aus dem Halbleiterkörper ausgekoppelt.

Schichtpaare aus hochdotierten entarteten Halbleiterschichten entgegengesetzten Leitungstyps sind bereits eingesetzt worden, um optoelektronische Bauelemente, wie mehrschichtige Strahlungsempfänger, die beispielsweise in M. Ilegems et al., Integrated Multijunction GaAs photodetector with high output voltage, in Applied Physics Letters 33 (7) 1978, Seiten 629 bis 631, beschrieben sind, oder mehrschichtige Solarzellen, die beispielsweise in D. L. Miller et al., Journal of Applied Physics 53 (1) 1982, Seiten 744 bis 748 beschrieben sind, zu entwickeln. Weiterhin wurden derartige pn-Übergänge aus hochdotierten entarteten Halbleiterschichten dazu verwendet, Stapel aus einzelnen Halbleiterlaserstrukturen monolithisch elektrisch in Serie zu schalten, wie es beispielsweise in C. P. Lee et al., Applied Physics Letters 30 (10) 1977, Seiten 535 bis 538, oder in der US 5,212,706 beschreiben ist.

In den genannten Fällen wird die Folge hochdotierter Schichten jedoch als elektrischer Kontakt zwischen optoelektronischen Bauelementen zu deren Hintereinanderschaltung eingesetzt. Im Gegensatz dazu wird bei dem oben beschriebenen erfindungsgemäßen optoelektronischen Bauelement die Folge hochdotierter Halbleiterschichten dazu verwendet, eine Resonator-spiegelschicht eines ersten Leitungstyps an eine Halbleiterschicht eines zweiten Leitungstyps anzukoppeln. Hierbei sind Teile der Schichtfolge z. B. eines VCSEL-Bauelements, wie es aus dem Stand der Technik bekannt ist, beispielsweise eine oder mehrere Schichten der Resontatorspiegelschicht oder eine Barriereschicht durch die hochdotierten entarteten Schichten ersetzt oder ergänzt.

Das erfindungsgemäße optoelektronische Halbleiterbauelement wird im Folgenden anhand von vier Ausführungsbeispielen in Verbindung mit den Figuren 1 bis 4 näher erläutert. Es zeigen:
Figur 1 eine schematische Darstellung einer Schichtstruktur eines ersten Ausführungsbeispieles,
Figur 2 eine schematische Darstellung einer Schichtstruktur eines zweiten Ausführungsbeispieles
Figur 3 eine schematische Darstellung einer Schichtstruktur eines dritten Ausführungsbeispieles und
Figur 4 eine schematische Darstellung einer Schichtstruktur eines vierten Ausführungsbeispieles.

In den Figuren sind gleiche oder gleichwirkende Bestandteile der Ausführungsbeispiele jeweils mit denselben Bezugszeigen versehen.

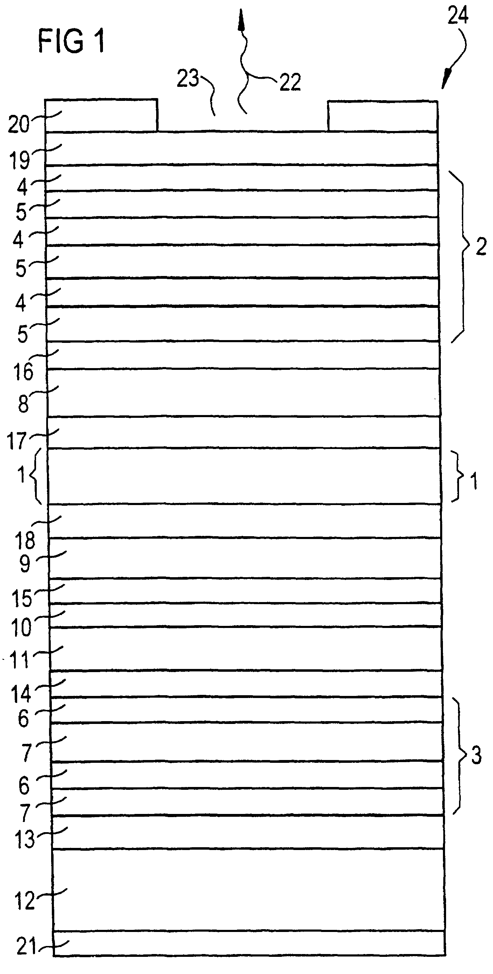

Bei der in Figur 1 gezeigten Schichtstruktur handelt es sich um den Halbleiterkörper 24 eines vertikal zur Oberfläche emittierenden Lasers, einer VCSEL-Diode, bei der die Laserstrahlung 22 durch die einem Halbleitersubstrat 12 gegenüberliegenden Seite des Halbleiterkörpers 24 aus diesem ausgekoppelt wird. Der auf dem Halbleitersubstrat 12 eines ersten Leitungstyps (z. B. n-Leitung) aufgebrachte Halbleiterkörper 24 besteht aus einer aktiven Zone 1, die als Vielfachquantentrogstruktur ausgebildet und zwischen einer ersten Barriereschicht 8 des ersten Leitungstyps und einer zweiten Barriereschicht 9 eines zweiten Leitungstyps (z. B. p-Leitung) eingeschlossen ist. Zwischen der ersten Barriereschicht 8 und der aktiven Zone 1 ist eine erste Anpassungsschicht 17 des ersten Leitungstyps und zwischen der zweiten Barriereschicht 9 und der aktiven Zone 1 ist eine zweite Anpassungsschicht 18 des zweiten Leitungstyps angeordnet. Bei geeigneter Wahl der Materialkombinationen für die aktive Zone 1 und die Barriereschichten 8,9 können die Anpassungsschichten 17,18 auch weggelassen sein.

Die auf der dem Substrat 12 abgewandten Seite der aktiven Zone 1 liegende erste Barriereschicht 8 ist über eine erste Zwischenschicht 16 des ersten Leitungstyps an eine Oberseiten-Bragg-Reflektorschicht 2 des ersten Leitungstyps angeschlossen.

Eine substratseitige Unterseiten-Bragg-Reflektorschicht 3 ist vom ersten Leitungstyp und über eine Pufferschicht 13 des ersten Leitungstyps an das Substrat 12 angeschlossen. An der dem Substrat 12 abgewandten Seite der Unterseiten-Bragg-Reflektorschicht 3 schließt sich eine erste hochdotierte, entartete Übergangsschicht 11 des ersten Leitungstyps an, die durch eine zweite Zwischenschicht 14 des ersten Leitungstyps mit der Unterseiten-Bragg-Reflektorschicht 3 verbunden ist. Auch auf diese Zwischenschicht 14 kann bei geeigneter Wahl der Materialien verzichtet werden.

Auf der dem Substrat abgewandten Seite der ersten hochdotierten, entarteten Übergangsschicht 11 schließt sich dieser eine zweite hochdotierte, entartete Übergangsschicht 10 des zweiten Leitungstyps an. Auf dieser ist wiederum optional eine dritte Zwischenschicht 15 des zweiten Leitungstyps aufgebracht, auf der die zweite Barriereschicht 9 angeordnet ist.

Auf der der aktiven Zone 1 abgewandten Seite der Oberseiten-Bragg-Reflektorschicht 2 befindet sich ein ohmscher Kontakt 20, wobei zwischen diesem und der Oberseiten-Bragg-Reflektorschicht 2 auch noch eine vierte Zwischenschicht 19 des ersten Leitungstyps angeordnet sein kann. Ein weiterer elektrischer Kontakt 21 befindet sich an der Rückseite des Substrats 12.

In Betrieb des Halbleiterbauelements wird über die Kontakte 20,21 an den Halbleiterkörper 24 eine elektrische Spannung derart angelegt, dass der pn-Übergang, der zwischen der ersten Barriereschicht 8 und der ersten Anpassungsschicht 17 einerseits und der zweiten Barriereschicht 9 und der zweiten Anpassungsschicht 18 andererseits an der aktiven Zone 1 gebildet ist, in Vorwärtsrichtung gepolt ist, und der pn-Übergang, der zwischen der ersten hochdotierten, entarteten Übergangsschicht 11 und der zweiten hochdotierten, entarteten Übergangsschicht 10 gebildet ist, in Rückwärtsrichtung gepolt ist. Für den Fall, daß der erste Leitungstyp n-Leitung und der zweite Leitungstyp p-Leitung ist, können die Ladungsträger aus dem Valenzband des Materials in der zweiten hochdotierten, entarteten Übergangsschicht 10 die Energiebarriere ins Leitungsband des Materials der ersten hochdotierten, entarteten Übergangsschicht 11 durchdringen, so dass der Strom auf der Seite der zweiten hochdotierten, entarteten Übergangsschicht 10 von Ladungsträgern des zweiten Leitungstyps getragen wird. Für den umgekehrten Fall - erster Leitungstyp p-Leitung und zweiter Leitungstyp n-Leitung - tunneln die Ladungsträger aus dem Leitungsband des Materials in der zweiten hochdotierten, entarteten Übergangsschicht 10 in das Valenzband des Materials der ersten hochdotierten, entarteten Übergangsschicht 11.

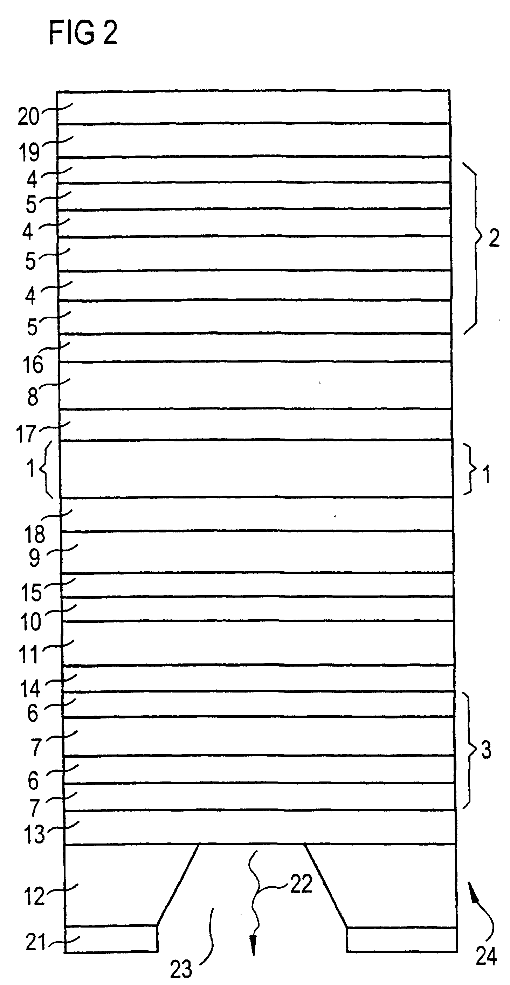

Das in Figur 2 gezeigte Ausführungsbeispiel unterscheidet sich von dem in Figur 1 gezeigten dadurch, daß hier die Laserstrahlung 22 durch das Halbleitersubstrat 12 hindurch aus dem Halbleiterkörper 24 ausgekoppelt wird. Dazu ist im Substrat 12 und in der Kontaktschicht 21 eine Ausnehmung 23 vorgesehen.

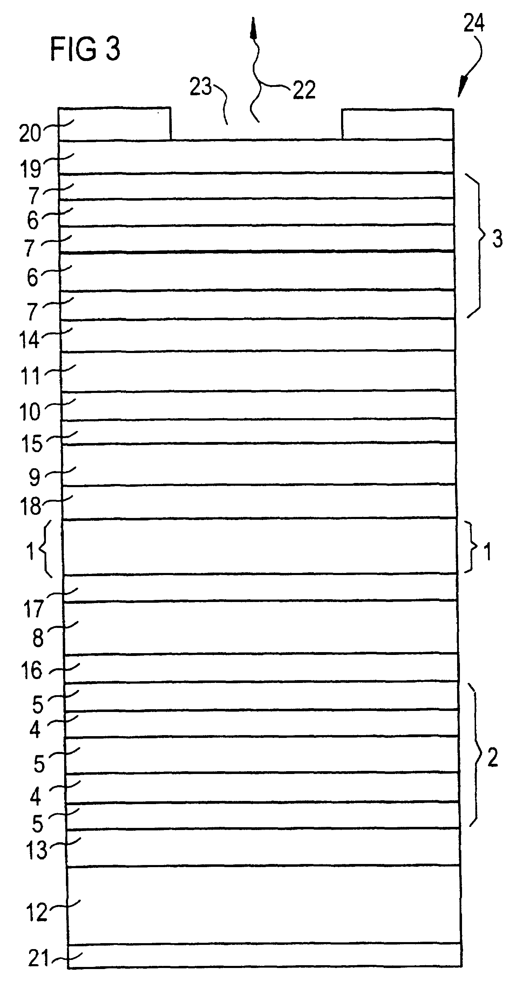

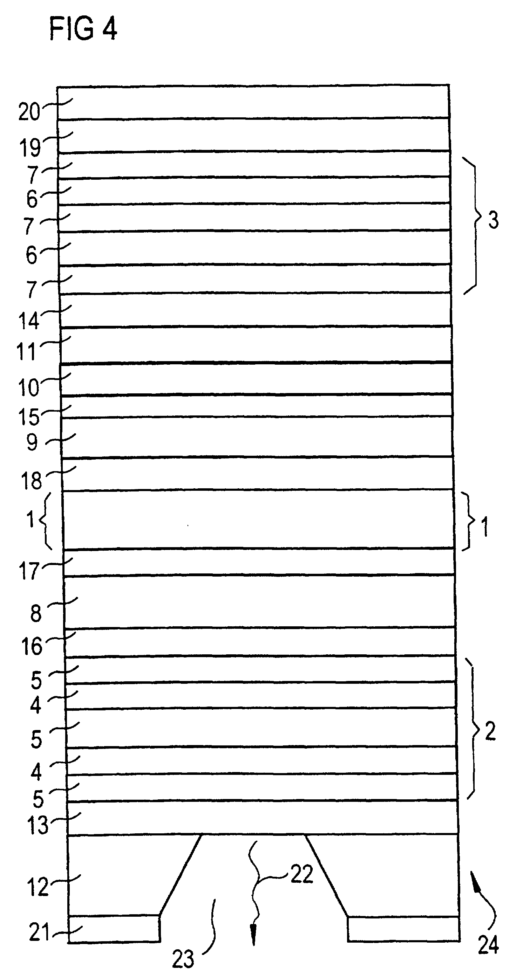

Im Unterschied zu den in den Figuren 1 und 2 dargestellten Ausführungsbeispielen des erfindungsgemäßen Bauelements befindet sich bei den Ausführungsbeispielen gemäß Figur 3 und Figur 4 die erste hochdotierte, entartete Übergangsschicht 11 und die zweite hochdotierte, entartete Übergangsschicht 10 auf der dem Substrat 12 abgewandten Seite der aktiven Zone 1. Der von den hochdotierten, entarteten Übergangsschichten 10,11 gebildete pn-Übergang liegt folglich zwischen der Oberseiten-Bragg-Reflektorschicht 3 und der aktiven Zone 1, derart, daß die zweite Übergangsschicht 10 zwischen dieser und der ersten Übergangsschicht 11 angeordnet ist. In der Anordnung nach Figur 3 wird die elektromagnetische Strahlung in steilem Winkel zu der dem Substrat 12 gegenüberliegenden Oberfläche des Halbleiterkörpers 24 durch einen transparenten oder mit einer Austrittsöffnung 23 versehenen Kontakt 20 hindurch ausgekoppelt. In der Ausführungsform nach Figur 4 wird die Lichtwelle 22 durch das Substrat 12 und den transparenten oder mit einer Durchtrittsöffnung 23 versehenen Kontakt 21 hindurch oder durch eine im Substrat 12 und im Kontakt 21 vorgesehene Ausnehmung 23 hindurch emittiert. Die Funktion der weiteren Zwischen- 14,15,16,19, Anpassungs- 17,18, Barriere- 8,9 und Spiegel-Schichten 2,3 und der aktiven Zone 1 sind im weiteren analog zu den Ausführungsbeispielen gemäß Figur 1 und Figur 2 zu verstehen.

Gemäß den Ausführungsbeispielen von Figur 1 und Figur 3 sind die Oberseiten-Bragg-Reflektorschicht 2 bzw. die Unterseiten-Bragg-Reflektorschicht 3 von sich abwechselnden Schichten 4,5 mit jeweils hohem und niedrigem Brechungsindex gebildet, deren Folge sich periodisch wiederholt. Analog ist die Unterseiten-Bragg-Reflektorschicht 3 bzw. die Oberseiten-Bragg-Reflektorschicht 2 aus sich abwechselnden Schichten 6,7 mit jeweils hohem und niedrigem Brechungsindex hergestellt. Die Dicke der jeweiligen Schicht wird so gewählt, dass sie ¼ der Wellenlänge der emittierten elektromagnetischen Strahlung dividiert durch den Brechungsindex des jeweils für die Schichten 4,5,6,7 verwendeten Materials ist. Dabei wird die elektrische Leitfähigkeit und der Aufbau der Schichten 4,5 so gewählt, dass das Reflexionsvermögen und die Leitfähigkeit vertikal zu dem Schichtstapel der Oberseiten-Bragg-Reflektorschicht 2 bzw. die Unterseiten-Bragg-Reflektorschicht 3 maximal ist. Die Reflektivität der jeweiligen Bragg-Reflektorschicht 2,3 wird durch die Anzahl der Schichtpaare eingestellt.

In den erfindungsgemäßen Ausführungen nach Figur 1 bzw. Figur 3 ist die Reflektivität der Oberseiten-Bragg-Reflektorschicht 2 bzw. 3 geringfügig geringer eingestellt als die der Unterseiten-Bragg-Reflektorschicht 3 bzw. 2, so dass die erzeugte elektromagnetische Welle über die der Substratseite gegenüberliegende Oberseite des Halbleiterkörpers 24 durch einen transparenten oder mit einer Austrittsöffnung 23 versehenen Oberseitenkontakt 20 hindurch ausgekoppelt wird.

Bei den Ausführungsbeispielen von Figur 2 und Figur 4 ist die Reflektivität der Unterseiten-Bragg-Reflektorschicht 3 bzw. 2 geringfügig geringer eingestellt als die der Oberseiten-Bragg-Reflektorschicht 2 bzw. 3, um das Licht durch das Substrat 12 oder durch eine Ausnehmung 23 im Substrat 12 hindurch aus dem Halbleiterkörper 24 auszukoppeln.

Bevorzugt werden n-leitende Schichten 4,5,6,7 in den Bragg-Reflektorschichten 2,3 verwendet, die beispielsweise Si-dotiert sind. Materialien für diese Schichten sind beispielsweise AlAs, AlₓGa₁₋ₓAs_{y}P_{1-y}, GaAs oder AlₓGa₁₋ₓAsₓSb₁₋ₓ, InₓGa₁₋ ₓAs_{y}P_{1-y} oder II-VI-Halbleitermaterialien, wie z. B. Zn_{1-x-y}CdₓMg_{y}Se, Zn₁₋ₓCdₓSe_{1-y}Te_{y}, BeₓMg_{y}Zn_{1-x-y}Te oder BeₓMg_{y}Zn_{1-x-y}Se.

Die zur Lichterzeugung verwendete aktive Zone 1 kann aus einer in der Regel undotierten oder schwach dotierten Heterostruktur bestehen, die als Einfach- oder Mehrfachquantentrog-Struktur ausgebildet sein kann, wobei die QW- bzw. MQW-Struktur in Barriereschichten 8,9 mit entgegengesetztem Leitungsstyp eingebettet ist. Dadurch wird der effektive elektrische Ladungsträgereinschluss in der aktiven Zone bei Injektion von Ladungsträgern durch Polung dieser p-i-n-Struktur in Durchlassrichtung erzielt. Die Dotierung ist im Fall von Elektronenleitung in einer der Barriereschicht 8 und 9 bevorzugt so einzustellen, dass sie zwischen 1*10¹⁶ cm⁻³ und 5^{*}10¹⁹cm⁻³ beträgt, was bevorzugtermaßen durch den Einbau von Si erreicht wird. Im Falle der Löcherleitung in der anderen der Barriereschicht 8 und 9 wird bevorzugt eine Dotierungskonzentration an Kohlenstoff oder Beryllium von 1*10¹⁶ cm⁻³ und 5^{*}10¹⁹ cm⁻³ verwendet.

Die Wellenlänge der erzeugten elektromagnetischen Strahlung kann über die Zusammensetzung und den Aufbau der MQW-Struktur 1, sowie der Anpassungsschichten 17,18 und der Barriereschichten 8,9 eingestellt werden. Bevorzugte Materialien für die aktive Zone sind beispielsweise InGaAsP und AlGaInAs oder II-VI-Halbleiter, wie BeZnCdSe oder ZnCdSeTe.

Die Barriereschichten 8,9 bestehen insbesondere bei einer In-GaAs/GaAs aufweisenden MQW-Struktur vorzugsweise aus AlGaAs, wobei der Al-Gehalt zwischen 10 und 50% liegt. Für die Anpassungsschichten 17,18 wird AlGaAs mit einer linearen Variation des Al-Gehalts von 0% bis beispielsweise 50% verwendet, je nachdem welchen Al-Gehalt die angrenzenden Schichten aufweisen. Die Pufferschicht 13 und die Zwischenschichten 14 und 19 bestehen in diesem bevorzugten Beispiel aus GaAs und die Zwischenschichten 15 und 16 aus AlGaAs. Als Kontaktschicht für die elektrischen Kontakte 20,21 ist beispielsweise eine Au/Ge- oder Ti/Pt/Au-Schichtenfolge verwendet.

Zur Injektion von Ladungsträgern in die aktive Zone wird an die elektrischen Kontakte 20,21 eine elektrische Spannung angelegt, in der Art, dass der p-i-n-Übergang der aktiven Zone in Vorwärtsrichtung gepolt ist. Hierbei wird in den Ausführungsbeispielen gemäß Figur 1 und Figur 2 ein Elektronenstrom durch die n-leitende Oberseiten-Bragg-Reflektorschicht 2 bzw. 3 in die aktive Zone 1 erzeugt. Aus dem gegenüberliegenden Unterseitenkontakt 21 werden bei dieser Polung Elektronen abgezogen. Für die Ausführungsbeispiele gemäß Figur 3 und Figur 4 erfolgt der Stromtransport in entgegengesetzter Richtung.

Im Bereich der hochdotierten, entarteten Übergangsschichten 10 und 11, die unterschiedlichen Leitungstyp besitzen, liegt eine Rückwärtspolung des dadurch gebildeten pn-Übergangs vor, wodurch Elektronen in dem sich dort aufbauenden hohen elektrischen Feld aus der ersten hochdotierten, entarteten Übergangsschicht 11 in die zweite hochdotierte, entartete Übergangsschicht 10 gezogen werden, was einem effektiven Löcherstrom entspricht. Hierbei beträgt für die erste hochdotierte, entartete Übergangsschicht 11 die Dicke bevorzugt zwischen 5 nm und 200 nm und die Dotierung für n-Leitung als ersten Leitungstyp zwischen 1^{*}10¹⁷ cm⁻³ und 1^{*}10²¹ cm⁻³ für p-Leitung als ersten Leitungstyp zwischen 1^{*}10¹⁷ cm⁻³ und 1^{*}10²¹ cm⁻³. Die Dicke der zweiten hochdotierten entarteten Übergangsschicht 10 liegt vorzugsweise zwischen 5 nm und 200 nm und die Dotierung in dieser Schicht für n-Leitung als zweiten Leitungstyp zwischen 1^{*}10¹⁷ cm⁻³ und 1^{*}10²¹ cm⁻³, für p-Leitung als zweiten Leitungstyp zwischen 1^{*}10¹⁷ cm⁻³ und 1^{*}10²¹ cm⁻³. Zur Anpassung der Dotierstoffkonzentrationen und Ladungsträgerpotentiale sind neben den hochdotierten, entarteten Übergangsschichten 10,11 auch Zwischenschichten 14,15 verwendet, wobei die Dotierung in der Zwischenschicht 14 vom gleichen Leitungstyp ist, wie in der ersten hochdotierten, entarteten Schicht 11 und die Dotierung der Zwischenschicht 15 vom gleichen Leitungstyp ist, wie die zweite hochdotierte, entartete Übergangsschicht 10. Unter Umständen kann zwischen der zweiten hochdotierten, entarteten Übergangsschicht 10 und der ersten hochdotierten, entarteten Übergangsschicht 11 eine dünne Zwischenschicht eingebracht sein, die entweder vom ersten Leitungstyp, vom zweiten Leitungstyp oder undotiert ist. Zur Einstellung der n-Leitung ist vorzugsweise Si als Dotierstoff verwendet, für p-Leitung kann vorzugsweise Kohlenstoff oder Beryllium als Dotierstoff verwendet sein. Als Materialien für die hochdotierten, entarteten Schichten 10,11 werden vorzugsweise Halbleitermateralien verwendet, die eine geringe Bandlücke und eine geringe effektive Ladungsträgermasse besitzen, insbesondere beispielsweise InGaAsP, InGaAlSb, InGaAlAs oder InGaAlP.

Die Anzahl, Dotierstoffkonzentration, Schichtdicke und Zusammensetzung der Zwischenschichten 14,15,16,17,18 kann in abweichenden Ausführungsbeispielen variieren, wobei darauf zu achten ist, dass die Potentialbarriere zwischen den hochdotierten, entarteten Schichten 10,11 dünn bleibt und somit von Ladungsträgern leicht durchdrungen werden kann und dass die Schichtdicken und Brechungsindizies der Zwischenschichten 14,15,16,17,18 sowie der hochdotierten Schichten 10,11, der Barriereschichten 8,9 und der aktiven Zone 1 so gewählt ist, dass sie konstruktiv zum Reflexionsvermögen der beiderseitigen Bragg-Reflektorschichten 2,3 und zur Maximierung der Intensität der elektromagnetischen Welle am Ort der aktiven Zone 1 beitragen.

Die Beschreibung der Art und Funktion der einzelnen Schichten in Zusammenhang mit dem erfindungsgemäßen Bauelement gemäß dem Ausführungsbeispiel von Figur 1 kann mit entsprechender Indizierung der Schichtnummern auf die Ausführungsbeispiele gemäß den Figuren 2 bis 4 übertragen werden.

Die Beschreibung des erfindungsgemäßen optoelektronischen Halbleiterbauelements anhand der Ausführungsbeispiele ist selbstverständlich nicht als Beschränkung der Erfindung auf diese Ausführungsbeispiele zu verstehen. Erfindungsgemäße VCSEL können ebenso auf der Basis anderer Halbleitermaterialien ausgebildet sein, wie z. B. GaAs, InAs, AlAs, GaN, AlN, InN, GaP, InP, AlP, GaSb, InSb, AlSb und auf diesen binären Verbindungen basierende Mischkristallsysteme, sowie ZnSe, CdSe, MgSe,BeSe, HgSe, ZnS, CdS, MgS, BeS, HgS, ZnTe, CdTe, MgTe, BeTe, HgTe, und daraus gebildete Mischkristallsysteme. Geeignete Materialien für das Substrat 12 sind beispielsweise Si, Ge, GaAs, InAs, InGaAs, GaP, InP, Al₂O₃, SiC, CdTe, CdZnTe, ZnO oder ZnSe.

## Patentansprüche

1. Optoelektronisches Bauelement mit mindestens einem zur Erzeugung elektromagnetischer Strahlung (22) geeigneten Halbleiterkörper (24),
bei dem über einem Halbleitersubstrat (12) mindestens eine aktive Zone (1) angeordnet ist,
innerhalb der bei Stromfluß durch den Halbleiterkörper (24) die elektromagnetische Strahlung (22) erzeugt wird und
die zwischen mindestens einer ersten Spiegelschicht (2) und mindestens einer zweiten Spiegelschicht (3) angeordnet ist,
**dadurch gekennzeichnet**,
daß die erste (2) und die zweite Spiegelschicht (3) Halbleitermaterial eines ersten Leitungstyps aufweisen und daß zwischen der aktiven Zone (1) und einer der beiden Spiegel-schichten (2,3) mindestens eine erste hochdotierte Übergangsschicht (11) des ersten Leitungstyps mit einer Dotierstoffkonzentration höher als 1x10¹⁷ cm⁻³ und mindestens eine zweite hochdotierte Übergangsschicht (10) eines zweiten Leitungstyps mit einer Dotierstoffkonzentration höher als 1x10¹⁷ cm⁻³ angeordnet sind, derart, daß die zweite hochdotierte entartete Übergangsschicht (10) zwischen der aktiven Zone (1) und der ersten hochdotierten entarteten Übergangsschicht (11) liegt.

2. Optoelektronisches Bauelement nach Anspruch 1,
**dadurch gekennzeichnet**,
daß die erste (11) und die zweite hochdotierte Übergangsschicht (10) entartete Halbleitermaterialien aufweisen.

3. Optoelektronisches Bauelement nach einem der Ansprüche 1 bis 2,
**dadurch gekennzeichnet**,
daß die erste (2) und die zweite Spiegelschicht (3) als Bragg-Reflektorschichten ausgebildet sind.

4. Optoelektronisches Bauelement nach einem der Ansprüche 1 bis 3,
**dadurch gekennzeichnet**,
dass die Spiegelschichten (2,3) n-leitend oder p-leitend dotiert sind.

5. Optoelektronisches Bauelement nach einem der Ansprüche 1 bis 4,
**dadurch gekennzeichnet,**
daß ein von der ersten hochdotierten Übergangsschicht (11) und der zweiten hochdotierten Übergangsschicht (10) ausgebildeter pn-Übergang derart angeordnet ist, daß er im Betrieb des Bauelements in Sperrichtung gepolt ist.

6. Optoelektronisches Bauelement nach einem der Ansprüche 1 bis 5,
**dadurch gekennzeichnet,**
daß eine der beiden Spiegelschichten (2,3) eine geringere Reflektivität aufweist als die andere und daß der Spiegelschicht (2,3) mit der geringeren Reflektivität eine zumindest für einen Teil der elektromagnetischen Strahlung (22) durchlässige Kontaktschicht (20,21) zugeordnet ist, derart, daß die elektromagnetische Strahlung (22) im Wesentlichen durch die Spiegelschicht (2,3) mit der geringeren Reflektivität und durch die Kontaktschicht (20,21) hindurch auskoppelbar ist.

7. Optoelektronisches Bauelement nach einem der Ansprüche 1 bis 6,
**dadurch gekennzeichnet,**
dass die Strahlung (22) durch einen transparenten oder mit einer Austrittsöffnung (23) versehenen Kontakt (20) hindurch an der dem Substrat (12) gegenüberliegenden Seite des Halbleiterkörpers (24) ausgekoppelt wird.

8. Optoelektronisches Bauelement nach einem der Ansprüche 1 bis 6,
**dadurch gekennzeichnet,**
dass die Strahlung (22) durch ein transparentes Substrat (12) und einen transparenten oder mit einer Austrittsöffnung (23) versehenen Kontakt (21) oder durch eine Ausnehmung (23) im Substrat (12) hindurch aus dem Halbleiterkörper (24) ausgekoppelt wird.

9. Optoelektronisches Bauelement nach einem der Ansprüche 1 bis 8,
**dadurch gekennzeichnet,**
dass mindestens eine der Spiegelschichten (2,3) monolithisch während des Herstellungsprozesses des Halbleiterkörpers aufgebracht ist.

10. Optoelektronisches Bauelement nach einem der Ansprüche 1 bis 8,
**dadurch gekennzeichnet,**
dass mindestens eine der Spiegelschichten (2,3) in hybrider Technik nach der Herstellung des Halbleiterkörpers (24) aufgebracht ist.

## Claims

1. Optoelectronic component having at least one semiconductor body (24) which is suitable for generating electromagnetic radiation (22),
in which at least one active zone (1) is arranged above a semiconductor substrate (12),
within which zone the electromagnetic radiation (22) is generated in the event of a current flow through the semiconductor body (24), and
which zone is arranged between at least one first mirror layer (2) and at least one second mirror layer (3),
characterized
in that the first (2) and the second mirror layer (3) have semiconductor material of a first conduction type, and in that at least one first heavily doped junction layer (11) of the first conduction type having a dopant concentration higher than 1×10¹⁷ cm⁻³ and at least one second heavily doped junction layer (10) of a second conduction type having a dopant concentration higher than 1×10¹⁷ cm⁻³ are arranged between the active zone (1) and one of the two mirror layers (2,3), in such a way that the second heavily doped, degenerate junction layer (10) lies between the active zone (1) and the first heavily doped, degenerate junction layer (11).

2. Optoelectronic component according to Claim 1,
characterized
in that the first (11) and the second heavily doped junction layer (10) have degenerate semiconductor materials.

3. Optoelectronic component according to one of Claims 1 to 2,
characterized
in that the first (2) and the second mirror layer (3) are designed as Bragg reflector layers.

4. Optoelectronic component according to one of Claims 1 to 3,
characterized
in that the mirror layers (2,3) are doped in an n-conducting or p-conducting fashion.

5. Optoelectronic component according to one of Claims 1 to 4,
characterized
in that a pn junction formed by the first heavily doped junction layer (11) and the second heavily doped junction layer (10) is arranged in such away that it is reverse-biased during operation of the component.

6. Optoelectronic component according to one of Claims 1 to 5,
characterized
in that one of the two mirror layers (2,3) has a lower reflectivity than the other, and in that the mirror layer (2, 3) having the lower reflectivity is assigned a contact layer (20,21) which is transmissive at least for part of the electromagnetic radiation (22), in such a way that the electromagnetic radiation (22) can be coupled out essentially through the mirror layer (2,3) having the lower reflectivity and through the contact layer (20,21).

7. Optoelectronic component according to one of Claims 1 to 6,
characterized
in that the radiation (22) is coupled out through a contact (20), which is transparent or provided with an exit opening (23), on that side of the semiconductor body (24) which is opposite to the substrate (12).

8. Optoelectronic component according to one of Claims 1 to 6,
characterized
in that the radiation (22) is coupled out from the semiconductor body (24) through a transparent substrate (12) and a contact (21), which is transparent or provided with an exit opening (23) , or through a recess (23) in the substrate (12).

9. Optoelectronic component according to one of Claims 1 to 8,
characterized
in that at least one of the mirror layers (2,3) is applied monolithically during the process for fabricating the semiconductor body.

10. Optoelectronic component according to one of Claims 1 to 8,
characterized
in that at least one of the mirror layers (2,3) is applied using hybrid technology after the fabrication of the semiconductor body (24).

## Revendications

1. Composant optoélectronique comportant au moins un élément (24) semi-conducteur convenant à la production de rayonnement (22) électromagnétique,
dans lequel il. est disposé au-dessus d'un substrat (12) semi-conducteur au moins une zone (1) active
à l'intérieur de laquelle le rayonnement (22) électromagnétique est produit en cas de flux de courant dans l'élément (24) semi-conducteur et
qui est disposé entre au moins une première couche (2) réfléchissante et au moins une deuxième couche (3) réfléchissante,
caractérisé en ce que la première couche (2) et la deuxième couche (3) réfléchissantes comportent un matériau semi-conducteur d'un premier type de conductivité et en ce qu'il est disposé entre la zone (1) active et l'une des deux couches (2, 3) réfléchissantes au moins une première couche (11) de transition fortement dopée du premier type de conductivité, ayant une concentration en substance dopante supérieure à 1^{*}10¹⁷ cm⁻³, et au moins une deuxième couche (10) de transition fortement dopée d'un deuxième type de conductivité, ayant une concentration en substance dopante supérieure à 1^{*}10¹⁷ cm⁻³, de telle manière que la deuxième couche (10) de transition fortement dopée, dégénérée, se trouve entre la zone (1) active et la première couche (11) de transition dopée, dégénérée.

2. Composant optoélectronique suivant la revendication 1, caractérisé en ce que la première couche (11) et la deuxième couche (10) de transition fortement dopées comportent des matériaux semi-conducteurs dégénérés.

3. Composant optoélectronique suivant l'une des revendications 1 à 2, caractérisé en ce que la première couche (2) et la deuxième couche (3) réfléchissantes sont réalisées en couches de réflecteur Bragg.

4. Composant optoélectronique suivant l'une des revendications 1 à 3, caractérisé en ce que les couches (2, 3) réfléchissantes sont dopées de manière à être conductrices d'un type de conductivité n ou conductrices d'un type de conductivité p.

5. Composant optoélectronique suivant l'une des revendications 1 à 4, caractérisé en ce qu'une jonction pn, réalisée par la première couche (11) de transition fortement dopée et la deuxième couche (10) de transition fortement dopée, est disposée de manière à être polarisée dans la direction de blocage pendant le fonctionnement du composant.

6. Composant optoélectronique suivant l'une des revendications 1 à 5, caractérisé en ce que l'une des deux couches (2, 3) réfléchissantes a un facteur de réflexion plus petit que l'autre et en ce qu'il est associé à la couche (2, 3) réfléchissante ayant le facteur de réflexion le plus petit une couche (20, 21) de contact transparente au moins pour une partie du rayonnement (22) électromagnétique, de telle manière que le rayonnement (22) électromagnétique peut être émis sensiblement au travers de la couche (2, 3) réfléchissante ayant le facteur de réflexion le plus petit et au travers de la couche (20, 21 ) de contact.

7. Composant optoélectronique suivant l'une des revendications 1 à 6, caractérisé en ce que le rayonnement est émis du côté de l'élément (24) semi-conducteur opposé au substrat (12) en passant par un contact (20) transparent ou muni d'une ouverture (23) de sortie.

8. Composant optoélectronique suivant l'une des revendications 1 à 6, caractérisé en ce que le rayonnement (22) est émis de l'élément (24) à semi-conducteur en passant par un substrat (12) transparent et un contact (21) transparent ou muni d'une ouverture (23) de sortie ou en passant par un évidement (23) ménagé dans le substrat (12).

9. Composant optoélectronique suivant l'une des revendications 1 à 8, caractérisé en ce qu'au moins l'une des couches (2, 3) réfléchissantes est déposée de manière monolithique pendant l'opération de fabrication de l'élément semi-conducteur.

10. Composant optoélectronique suivant l'une des revendications 1 à 8, caractérisé en ce qu'au moins l'une des couches (2, 3) réfléchissantes est déposée en technique hybride après la production de l'élément (24) semi-conducteur.
